# EUROPÄISCHE PATENTSCHRIFT

(11) **EP 3 399 359 B1**
(45) Veröffentlichungstag und Bekanntmachung des Hinweises auf die Patenterteilung: **09.12.2020**
(21) Anmeldenummer: 17169296.5
(22) Anmeldetag: 03.05.2017
(51) Int. Cl.: G02B 6/42, G02B 6/36, G02B 6/38

(54) **STECKVERBINDUNGSANORDNUNG UND VERWANDTES ÜBERWACHUNGSVERFAHREN**
PLUG CONNECTION ASSEMBLY AND RELATED MONITORING PROCESS
AGENCEMENT DE FICHES CONNECTÉES ET PROCÉDÉ DE SUPERVISION DE CETTE CONNEXION

(43) Veröffentlichungstag der Anmeldung: 07.11.2018
(73) Patentinhaber: TRUMPF Schweiz AG, 7214 Grüsch (CH)
(72) Erfinder: Hürlimann, Thomas, 7310 Bad Ragaz (CH)
(74) Vertreter: Kohler Schmid Möbus Patentanwälte

(56) Entgegenhaltungen:
- EP-A1- 1 811 715
- DE-A1- 4 229 566
- DE-C1- 19 950 764
- US-A1- 2002 081 076
- US-A1- 2002 081 080

## Beschreibung

Die Erfindung betrifft eine Steckverbindungsanordnung mit einem ersten Steckverbindungsteil und einem zweiten Steckverbindungsteil, wobei das zweite Steckverbindungsteil als Empfangssteckverbindungsteil mit einer Empfangseinrichtung ausgebildet ist und die Empfangseinrichtung mit einer ersten Erfassungseinrichtung zur Erfassung des durch die Empfangseinrichtung empfangenen Signals verbunden ist.

Weiterhin betrifft die Erfindung ein Verfahren zur Überwachung einer Steckverbindung, bei dem ein zeitlich veränderliches Signal über eine Sendeeinrichtung eines Sendesteckverbindungsteils berührungslos gesendet wird und durch eine Empfangseinrichtung eines Empfangssteckverbindungsteils empfangen wird.

Für den Transport von Laserlicht werden häufig Lichtleiter, insbesondere Lichtleitfasern, eingesetzt. Die Lichtleiter werden über Steckverbindungen angeschlossen. Wenn eine solche Steckverbindung gelöst wird, muss sichergestellt werden, dass auch die Lichtquelle abgeschaltet wird, da das austretende Licht schädlich sein kann, insbesondere bei einem Benutzer Augenschäden verursachen kann.

Die Überwachung einer Steckverbindung über einen Kontaktring, der zwei Kontakte kurzschließt, ist bekannt. Eine berührende Steckverbindungsüberwachung ist jedoch fehleranfällig.

Aus der US 2002/0081076 A1 ist es bekannt, an einem Steckerteil einen Permanentmagneten vorzusehen und in einem Steckerteil einen Hallsensor vorzusehen. Damit ist zwar eine berührungslose Erkennung möglich, ob ein Stecker eingesteckt ist, oder nicht. Allerdings kann bei dieser Art von Überwachung nicht detektiert werden, ob der Hallsensor defekt ist und dies zu einem sicheren Abschalten des Lasergenerators führt. Der Oberbegriff des Anspruchs 1 ist aus der DE 42 29 566 A1 und der US 2002/081080 A1 bekannt.

Aufgabe der vorliegenden Erfindung ist es, eine Steckverbindungsanordnung bereitzustellen, durch die eine Sicherheitsfunktion realisierbar ist, dahingehend, dass eine nicht ordnungsgemäße Steckverbindung zuverlässig erkannt und eine Strahlquelle bei fehlerhafter Steckverbindung zuverlässig ausgeschaltet werden kann.

Gelöst wird diese Aufgabe erfindungsgemäß durch eine Steckverbindungsanordnung nach Anspruch 1.

Somit kann eine zweikanalige Überwachung stattfinden. Wird in einem der Kanäle ein Fehler erkannt, kann dies automatisch zur Abschaltung einer Strahlquelle, insbesondere Lichtquelle, führen.

Die erste und/oder zweite Erfassungseinrichtung kann mit einer eigenen Auswerteeinrichtung verbunden sein, die eingerichtet ist, das durch die jeweilige Erfassungseinrichtung erfasste Signal mit einem Referenzsignal zu vergleichen. Dabei kann das Referenzsignal das zu übertragende Signal bestimmen. Insbesondere kann überwacht werden, ob das durch die Erfassungseinrichtungen erfasste Signal die gleiche Signalform aufweist wie das Referenzsignal. Durch die Verwendung eigener Auswerteeinrichtungen kann jede Erfassungseinrichtung hinsichtlich ihrer Funktionsfähigkeit überprüft und überwacht werden.

Die Auswerteeinrichtungen können datentechnisch miteinander verbunden sein. Beispielsweise können sie über einen Datenbus verbunden sein. Die Auswerteeinrichtungen können sich dadurch gegenseitig überwachen und auch die Ergebnisse des Vergleichs des erfassten Signals mit dem Referenzsignal austauschen.

Sowohl das Sendesteckverbindungsteil als auch das Empfangssteckverbindungsteil kann einen Lichtleiter aufweisen. Dadurch ist die Steckverbindungsanordnung für Laseranwendungen geeignet. Der Lichtleiter kann zum Leistungstransport in der Laserbearbeitung geeignet sein, z.B. ein Multimode-Leiter, PCF-Leiter oder Hollow-Core-Leiter mit entsprechenden Zerstörschwellen sein.

Das Sendesteckverbindungsteil kann am Ende eines einen Lichtleiter aufweisenden Lichtleitkabels angeordnet sein und es kann eine Signalleitung vorgesehen sein, die entlang des Lichtleitkabels geführt ist. Die Signalleitung kann als elektrische oder optische Leitung ausgebildet sein. Beispielsweise kann die Signalleitung in der Ummantelung des Kabels geführt sein. Insbesondere kann die Signalleitung parallel zum Lichtleiter geführt sein. Alternativ ist es denkbar, dass der Lichtleiter zur Signalübertragung genutzt wird.

Es kann ein Signalerzeuger vorgesehen sein, der mit der Sendeeinrichtung verbunden ist und mit zumindest einer Auswerteeinrichtung datentechnisch verbunden ist. Somit kann der Auswerteeinrichtung über die datentechnische Verbindung mitgeteilt werden, welches Signal durch den Signalerzeuger generiert wird, so dass die Auswerteeinrichtung weiß, welches Empfangssignal zu erwarten ist und somit beurteilen kann, ob durch die Empfangseinrichtung das von der Sendeeinrichtung gesendete Signal empfangen wurde. Insbesondere kann durch die datentechnische Verbindung des Signalerzeugers mit der Auswerteeinrichtung das Referenzsignal oder ein oder mehrere dieses beschreibende Parameter übertragen werden. Dadurch, dass die Auswerteeinrichtungen im Fall mehrerer Auswerteeinrichtungen ebenfalls datentechnisch miteinander verbunden sind, kann das Referenzsignal oder ein oder mehrere dieses beschreibende Parameter von der einen Auswerteeinrichtung an die andere Auswerteeinrichtung übertragen werden, so dass auch diese beurteilen kann, ob die zugeordnete Empfangseinrichtung das richtige Signal empfängt, welches dafür spricht, dass die Steckverbindungsanordnung intakt ist.

Die Sendeeinrichtung kann eine Spule und die Empfangseinrichtung kann einen Hallsensor umfassen. Diese Ausgestaltung hat Vorteile, wenn die Sende- und/oder Empfangseinrichtung von nicht magnetischem Material umgeben ist. Das magnetische Feld kann nicht-magnetische Materialien, wie Kunststoff, Aluminium und rostfreie Stähle durchdringen. Insbesondere kann durch die Spule ein niederfrequentes Signal übertragen werden und von dem Hallsensor empfangen werden. Diese Art der Signalübertragung ist zuverlässiger als dies bei einer RFID-Kopplung der Fall wäre, wo hochfrequente Signale übertragen werden. Insbesondere kann die als Spule ausgebildete Sendeeinrichtung abhängig von der Stromrichtung und der Stromstärke ein magnetisches Feld erzeugen. Ein Hallsensor reagiert auf das erzeugte magnetische Feld und gibt ein zur magnetischen Feldstärke proportionales Spannungssignal aus. Stimmt der Signalverlauf des Spannungssignals mit dem Signalverlauf des modulierten Spulenstroms überein, ist die Steckverbindung in Ordnung. Diese Lösung der Überwachung hat zusätzlich den Vorteil, dass das Kabel, das an einem Steckverbindungsteil angeschlossen ist, auf dem gesamten Transportweg des Lichts überwacht wird.

Wenn die beiden Leitungen durch irgend einen Grund kurzgeschlossen werden (wenn z. B. durch mechanisch dauernde Beanspruchung eine Faser des Schirms bricht und sich durch die Isolation durcharbeitet, entsteht ein Kurzschluss), fließt kein Strom mehr über die Spule. Damit kommt auch kein Signal mehr beim Empfänger an und die Strahlquelle wird abgeschaltet.

Die Spule kann einen weichmagnetischen Kern aufweisen. Durch diese Maßnahme wird die magnetische Flussdichte erhöht.

Die Auswerteeinrichtungen können als Mikrocontroller ausgebildet sein. Mikrocontroller sind kostengünstig, zuverlässig und häufig ohnehin im Bereich der Steckverbindungsanordnung vorhanden und können für die Überwachung der Steckverbindungsanordnung genutzt werden. Insbesondere kann das durch die Empfangseinrichtung empfangene Signal durch zwei unabhängige Mikrocontroller verglichen werden. Stimmt der Signalverlauf des empfangenen Signals mit dem in der Spule erzeugten Strom überein, ist die Steckverbindung in Ordnung. Andernfalls wird als Fehlerreaktion die zugehörige Strahlquelle, deren Signal über die Steckverbindungsanordnung übertragen werden soll, ausgeschaltet.

Der Signalerzeuger kann einen Mikrocontroller umfassen. Der Mikrocontroller kann die Signalform des Signals vorgeben, das durch die Sendeeinrichtung übertragen werden soll. Insbesondere kann der Mikrocontroller beispielsweise eine Leistungsversorgungsquelle, insbesondere eine Stromquelle, ansteuern und somit Richtung und Stromstärke des Stromes vorgeben, der durch die als Spule ausgebildete Sendeeinrichtung fließt. Insbesondere kann auf diese Art und Weise ein zeitlich veränderliches Signal erzeugt werden.

Es können lediglich zwei Mikrocontroller vorgesehen sein. Dadurch kann die Anzahl von Komponenten eingespart werden. Die zwei Mikrocontroller können entweder sende- oder empfangsseitig angeordnet sein, also im Bereich des Sendesteckverbindungsteils oder im Bereich des Empfangssteckverbindungsteils. Alternativ kann vorgesehen sein, dass sendeseitig und empfangsseitig jeweils zwei Mikrocontroller vorgesehen sind. Die empfangsseitigen und sendeseitigen Mikrocontroller können über einen Datenbus verbunden sein. Es müssen damit nur Daten und keine analogen Signale übertragen werden, so dass keine eigenen Analogübertragungsleitungen benötigt werden. Empfängerseitig ohnehin vorhandene Mikrocontroller können verwendet werden. Diese Ausgestaltung ist weniger störanfällig als wenn nur zwei Mikrocontroller verwendet würden, die sendeseitig vorgesehen sind. In diesem Fall müsste ein Analogsignal, nämlich das empfangene Signal, zur Sendeseite zurückübertragen werden.

Die Sendeeinrichtung und/oder die Empfangseinrichtung können im jeweiligen Steckverbindungsteil durch ein nicht-magnetisches Material geschützt angeordnet sein. Dadurch entsteht ein mechanischer Schutz für die Sendeeinrichtung und/oder die Empfangseinrichtung. Es entsteht ein robuster Steckverbinder. Als nicht magnetische Materialien kommen beispielsweise Kunststoffe, Aluminium und gewisse Stähle in Frage.

In den Rahmen der Erfindung fällt außerdem ein Verfahren zur Überwachung einer Steckverbindung nach Anspruch 12. Eine berührungslose Übertragung eines Signals hat gegenüber einer kontaktgebundenen Übertragung Vorteile, da sie gegen Verschmutzungen und fehlerhafte Kontaktierung weniger störanfällig ist. Es kann ein elektrisches oder optisches Signal berührungslos übertragen werden. Insbesondere, wenn zwei Erfassungseinrichtungen und jeweils zugeordnete Auswerteeinrichtungen vorgesehen sind, kann eine zweikanalige Überwachung erfolgen, wodurch die Sicherheit der Überwachung erhöht wird. Dadurch, dass ein zeitlich veränderliches Signal übertragen wird, kann bei mehreren Einsteckmöglichkeiten außerdem die Zuordnung überprüft werden und festgestellt werden, ob das richtige Steckverbindungsteil eingesteckt wurde.

Das zeitlich veränderliche Signal kann insbesondere ständig über die Sendeeinrichtung gesendet werden.

Durch die Auswerteeinrichtung kann überprüft werden, ob das erfasste Signal einem erwarteten Signal entspricht. Dazu ist es hilfreich, wenn den Auswerteeinrichtungen bekannt ist, welches Signal übertragen werden soll.

In Abhängigkeit der Auswertung kann ein an die Steckverbindung angeschlossenes Gerät abgeschaltet werden. Insbesondere kann das Gerät, beispielsweise eine Strahlquelle, abgeschaltet werden, wenn das empfangene bzw. erfasste Signal nicht einem erwarteten Signal entspricht. Eine Abschaltung kann insbesondere dann erfolgen, wenn durch eine der Auswerteeinrichtungen erkannt wird, dass das empfangene Signal nicht mit einem gesendeten Signal übereinstimmt oder kein Signal empfangen wird.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung ist ein Ausführungsbeispiel der Erfindung dargestellt und in der nachfolgenden Beschreibung näher erläutert.

Es zeigen:
- Fig. 1: eine Ausführungsform eines Teils einer Steckverbindungsanordnung;
- Fig. 2: einen Teil der Steckverbindungsanordnung der Figur 1 mit weiteren Komponenten der Steckverbindungsanordnung;
- Fig. 3a: die Signalform eines Signals, welches an eine Sendeeinrichtung gegeben wird,
- Fig. 3b: die Signalform, die empfangsseitig durch eine Erfassungseinrichtung erfasst wird;
- Fig. 4: eine schematisierte Darstellung einer alternativen Ausführungsform einer Steckverbindungsanordnung.

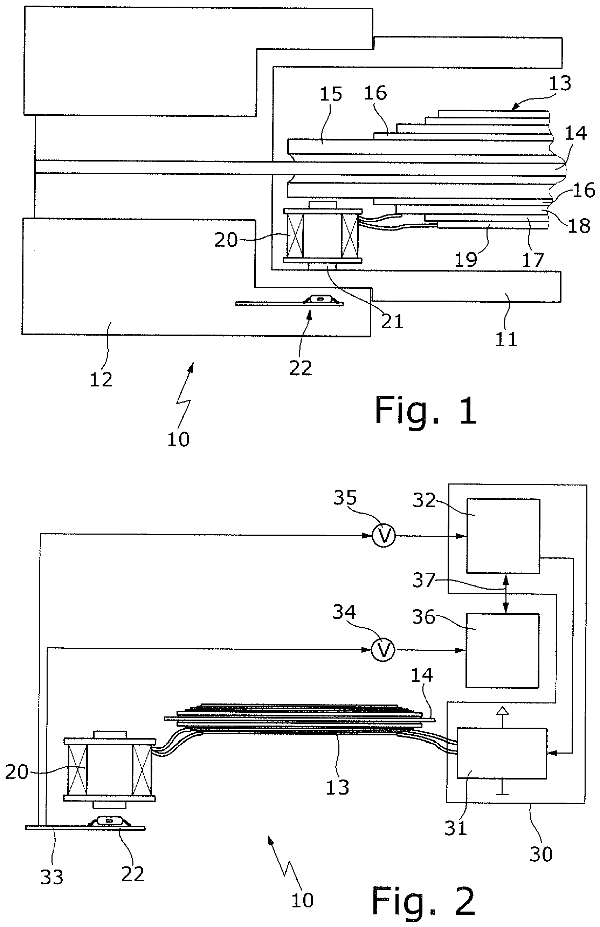

Die Figur 1 zeigt einen Teil einer Steckverbindungsanordnung 10 mit einem Sendesteckverbindungsteil 11 und einem Empfangssteckverbindungsteil 12. Das Sendesteckverbindungsteil 11 ist in das Empfangssteckverbindungsteil 12 eingesteckt. Das Sendesteckverbindungsteil 11 weist in der gezeigten Ausführungsform ein Lichtleitkabel 13 mit einem Lichtleiter 14 auf. Der Lichtleiter 14 ist in einem Schutzwendel 15 angeordnet, an den sich wiederum eine Isolation 16 radial nach außen anschließt. Zwischen der Isolation 16 und der Isolation 17 ist eine als Schirm ausgebildete Signalleitung 18 angeordnet. Die Isolation 17 ist wiederum von einer zweiten als Schirm ausgebildeten Signalleitung 19 umgeben. Der Lichtleiter 14 ist demnach von einer Ummantelung umgeben, wobei die Signalleitungen 18 und 19 in der Ummantelung parallel zum Lichtleiter 14 geführt sind. Eine eine Spule umfassende Sendeeinrichtung 20 ist über die Signalleitung 18 und die Signalleitung 19 mit einem hier nicht dargestellten Signalerzeuger verbunden.

Die Spule der Sendeeinrichtung 20 weist einen weichmagnetischen Kern 21 auf. Durch die Sendeeinrichtung 20 kann ein zeitlich veränderliches Signal berührungslos zu einer Empfangseinrichtung 22 im Empfangssteckverbindungsteil 12 übertragen werden. Die Empfangseinrichtung 22 umfasst im gezeigten Ausführungsbeispiel einen Hallsensor.

Der Lichtleiter 14 erstreckt sich im Inneren des Sendesteckverbindungsteils 11 bis in das Empfangssteckverbindungsteil 12. Über die Steckverbindungsanordnung 10 kann demnach ein optisches Signal, insbesondere Laserlicht, übertragen werden.

In der Figur 2 sind die zur Signalübertragung eines Stecküberwachungssignals benötigten Komponenten der Steckverbindungsanordnung 10 dargestellt. Die eigentlichen Steckverbindungsteile 11, 12 sind nicht dargestellt.

Hier ist zu erkennen, dass ein Signalerzeuger 30 über die Signalleitungen 18, 19 des Lichtleitkabels 13 mit der Sendeeinrichtung 20 verbunden ist. Der Signalerzeuger 30 umfasst eine Leistungsversorgungsquelle, insbesondere eine Stromquelle 31, die durch eine Auswerteeinrichtung 32 mit einem Pulsmuster angesteuert wird. Dadurch wird ein zeitlich veränderliches Signal generiert, welches über die Signalleitungen 18, 19 parallel zum Lichtleiter 14 übertragen wird. Die Stromquelle 31 könnte alternativ als H-Brücke ausgebildet sein.

Die Empfangseinrichtung 22, die einen Hallsensor aufweist, der auf einer Sensorplatine 33 angeordnet ist, empfängt ein von der Sendeeinrichtung 20 ausgesendetes Signal. Insbesondere wird durch die Sendeeinrichtung 20 ein zeitlich veränderliches elektromagnetisches Feld generiert, da die Sendeeinrichtung 20 durch den Signalerzeuger 30 mit einem zeitlich veränderlichen Strom gespeist wird. Das von der Empfangseinrichtung 22 empfangene Signal wird durch zwei Erfassungseinrichtungen 34, 35 erfasst. Das erfasste Signal wird an Auswerteeinrichtungen 32, 36 weitergeleitet, wo es mit einem Referenzsignal, insbesondere dem Signal, welches durch den Signalerzeuger 30 erzeugt wurde, verglichen wird. Damit auch die Auswerteeinrichtung 36 Kenntnis über das Referenzsignal erlangt, sind die Auswerteeinrichtungen 32, 36 datentechnisch, insbesondere über einen CAN-Bus 37 miteinander verbunden. Außerdem können die Auswerteeinrichtung 32, 36 über die datentechnische Verbindung auch die Vergleichsergebnisse austauschen. Die Auswerteeinrichtungen 32, 36 sind mit einer nicht gezeigten Strahlquelle verbunden, die durch jede der Auswerteeinrichtungen 32, 36 abgeschaltet werden kann, sollte das erfasste Signal nicht mit dem Referenzsignal übereinstimmen.

Für den Signalvergleich ist es ausreichend, wenn die Signalformen miteinander verglichen werden.

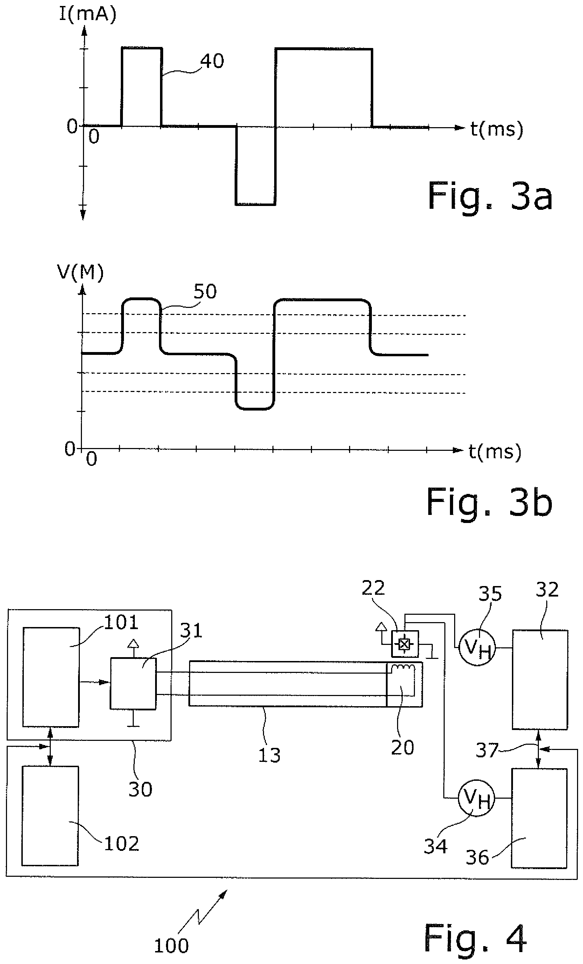

Die Figur 3a zeigt beispielhaft einen Strom 40, der zeitlich veränderlich ist und durch den Signalerzeuger 30 erzeugt wird. Wird dieser Strom 40 in die Spule der Sendeeinrichtung 20 eingespeist, so entsteht ein zeitlich veränderliches elektromagnetisches Feld. Dieses kann durch die Empfangseinrichtung 22 erfasst werden, so dass durch die Erfassungseinrichtungen 34, 35 als Empfangssignal eine zeitlich veränderliche Spannung 50 ausgegeben wird. Die Signale 40, 50 können durch die Auswerteeinrichtungen 32, 36 miteinander verglichen werden. Sie weisen dieselbe Signalform auf, was dafür spricht, dass die Steckverbindung in Ordnung ist.

Dadurch, dass zwei Erfassungseinrichtungen 34, 35 mit zugeordneten Auswerteeinrichtungen 32, 36 vorgesehen sind, erfolgt die Auswertung zweikanalig. Dadurch wird die Sicherheit der Überwachung der Steckverbindung erhöht.

Die Figur 4 zeigt eine alternative Ausführungsform einer Steckverbindungsanordnung 100. Die den der Figur 2 entsprechenden Komponenten entsprechenden Komponenten tragen dieselben Bezugsziffern. Hier sind die Auswerteeinrichtungen 32, 36 empfängerseitig angeordnet. Es sind nicht nur die Auswerteeinrichtungen 32, 36 über einen Datenbus 37 datentechnisch miteinander verbunden, sondern auch eingangsseitig vorgesehene Auswerteeinheiten 101, 102. Die Auswerteeinheit 101 ist dabei Bestandteil des Signalerzeugers 30, der wiederum eine Stromquelle 31 aufweist, die mit dem Lichtleitkabel 13 verbunden ist. Die Auswerteeinheiten 32, 36, 101, 102 sind alle als Mikrocontroller ausgebildet. Sämtliche Mikrocontroller sind datentechnisch miteinander verbunden und können entsprechend Daten miteinander austauschen.

## Patentansprüche

1. Steckverbindungsanordnung (10, 100) mit einem ersten Steckverbindungsteil und einem zweiten Steckverbindungsteil, die ineinander einsteckbar sind, wobei das zweite Steckverbindungsteil als Empfangssteckverbindungsteil (12) mit einer Empfangseinrichtung (22) ausgebildet ist und die Empfangseinrichtung (22) mit einer ersten Erfassungseinrichtung (34, 35) zur Erfassung des durch die Empfangseinrichtung (22) empfangenen Signals verbunden ist, wobei die Steckverbindungsanordnung die erste Erfassungseinrichtung (34,35) aufweist, wobei das erste Steckverbindungsteil als Sendesteckverbindungsteil (11) ausgebildet ist, das eine Sendeeinrichtung (20) zur berührungslosen Übertragung eines Signals aufweist, **dadurch gekennzeichnet, dass** die Empfangseinrichtung (22) mit einer zweiten Erfassungseinrichtung (34, 35) zur Erfassung des durch die Empfangseinrichtung (22) empfangenen Signals verbunden ist, wobei die Steckverbindungsanordnung neben der ersten Erfassungseinrichtung (34,35) die zweite Erfassungseinrichtung (34,35) aufweist.

2. Steckverbindungsanordnung nach Anspruch 1, **dadurch gekennzeichnet, dass** die erste und/oder zweite Erfassungseinrichtung (34, 35) mit einer eigenen Auswerteeinrichtung (32, 36) verbunden sind, die eingerichtet ist, das durch die jeweilige Erfassungseinrichtung (34, 35) erfasste Signal mit einem Referenzsignal zu vergleichen.

3. Steckverbindungsanordnung nach Anspruch 2, **dadurch gekennzeichnet, dass** die Auswerteeinrichtungen (32, 36) datentechnisch miteinander verbunden sind.

4. Steckverbindungsanordnung nach einem der vorhergehenden Ansprüche, **dadurch gekennzeichnet, dass** sowohl das Sendesteckverbindungsteil (11) als auch das Empfangssteckverbindungsteil (12) einen Lichtleiter (14) aufweist.

5. Steckverbindungsanordnung nach einem der vorhergehenden Ansprüche, **dadurch gekennzeichnet, dass** das Sendesteckverbindungsteil (11) am Ende eines einen Lichtleiter (14) aufweisenden Lichtleitkabels (13) angeordnet ist und eine Signalleitung (18) vorgesehen ist, die entlang des Lichtleitkabels (13) geführt ist.

6. Steckverbindungsanordnung nach einem der vorhergehenden Ansprüche, **dadurch gekennzeichnet, dass** ein Signalerzeuger (30) vorgesehen ist, der mit der Sendeeinrichtung (20) verbunden ist und mit zumindest einer Auswerteeinrichtung (32, 36, 101, 102) datentechnisch verbunden ist.

7. Steckverbindungsanordnung nach einem der vorhergehenden Ansprüche, **dadurch gekennzeichnet, dass** die Sendeeinrichtung (20) eine Spule und die Empfangseinrichtung (22) einen Hallsensor umfasst.

8. Steckverbindungsanordnung nach einem der Ansprüche 2 bis 7, **dadurch gekennzeichnet, dass** die Auswerteeinrichtungen (32, 36, 101, 102) als Mikrocontroller ausgebildet sind.

9. Steckverbindungsanordnung nach einem der vorhergehenden Ansprüche 6 bis 8, **dadurch gekennzeichnet, dass** der Signalerzeuger (30) einen Mikrocontroller umfasst.

10. Steckverbindungsanordnung nach einem der vorhergehenden Ansprüche, **dadurch gekennzeichnet, dass** sendeseitig und empfangsseitig jeweils zwei Mikrocontroller vorgesehen sind.

11. Steckverbindungsanordnung nach einem der vorhergehenden Ansprüche, **dadurch gekennzeichnet, dass** die Sendeeinrichtung (20) und/oder die Empfangseinrichtung (22) im jeweiligen Steckverbindungsteil (11, 12) durch ein nicht-magnetisches Material geschützt angeordnet sind.

12. Verfahren zur Überwachung einer Steckverbindung, bei dem ein zeitlich veränderliches Signal über eine Sendeeinrichtung (20) eines Sendesteckverbindungsteils (11) berührungslos gesendet wird und durch eine Empfangseinrichtung (22) eines Empfangssteckverbindungsteils (12) empfangen wird, wobei das Sendesteckverbindungsteil (11) und das Empfangssteckverbindungsteil (12) ineinander einsteckbar sind, und wobei das durch die Empfangseinrichtung (22) empfangene Signal durch zwei voneinander unabhängigen Erfassungseinrichtungen (34, 35) erfasst und jeweils einer Auswerteeinrichtung (32, 36) zugeführt wird.

13. Verfahren nach Anspruch 12, **dadurch gekennzeichnet, dass** durch die Auswerteeinrichtungen (32, 36) überprüft wird, ob das erfasste Signal einem erwarteten Signal entspricht.

14. Verfahren nach Anspruch 13, **dadurch gekennzeichnet, dass** in Abhängigkeit der Auswertung ein an die Steckverbindung angeschlossenes Gerät abgeschaltet wird.

## Claims

1. Connector arrangement (10, 100) comprising a first connector part and a second connector part which can be inserted into one another, the second connector part being in the form of a receiving connector part (12) comprising a receiver (22), and the receiver (22) being connected to a first sensing device (34, 35) for sensing the signal received by the receiver (22), wherein the connector arrangement comprises the first sensing device (34, 35), the first connector part being in the form of a transmitting connector part (11) which has a transmitter (20) for the contactless transmission of a signal, **characterized in that** the receiver (22) is connected to a second sensing device (34, 35) for sensing the signal received by the receiver (22), wherein the connector arrangement comprises the second sensing device (34, 35) in addition to the first sensing device (34, 35).

2. Connector arrangement according to claim 1, **characterized in that** the first and/or second sensing device(s) (34, 35) is/are each connected to a separate analysis device (32, 36) configured to compare the signal sensed by the particular sensing device (34, 35) with a reference signal.

3. Connector arrangement according to claim 2, **characterized in that** the analysis devices (32, 36) are interconnected for data transfer.

4. Connector arrangement according to any of the preceding claims, **characterized in that** both the transmitting connector part (11) and the receiving connector part (12) have an optical waveguide (14).

5. Connector arrangement according to any of the preceding claims, **characterized in that** the transmitting connector part (11) is arranged at the end of a fiber optic cable (13) having an optical waveguide (14), and a signal line (18) extending along the fiber optic cable (13) is provided.

6. Connector arrangement according to any of the preceding claims, **characterized in that** a signal generator (30) is provided, which is connected to the transmitter (20) and connected to at least one analysis device (32, 36, 101, 102) for data transfer.

7. Connector arrangement according to any of the preceding claims, **characterized in that** the transmitter (20) has a coil, and the receiver (22) has a Hall-effect sensor.

8. Connector arrangement according to any of claims 2 to 7, **characterized in that** the analysis devices (32, 36, 101, 102) are in the form of microcontrollers.

9. Connector arrangement according to any of preceding claims 6 to 8, **characterized in that** the signal generator (30) has a microcontroller.

10. Connector arrangement according to any of the preceding claims, **characterized in that** two microcontrollers are respectively provided on the transmission side and the reception side.

11. Connector arrangement according to any of the preceding claims, **characterized in that** the transmitter (20) and/or the receiver (22) is/are protected by a non-magnetic material in the particular connector part (11, 12).

12. Method for monitoring a connector, in which a temporally variable signal is contactlessly transmitted by a transmitter (20) of a transmitting connector part (11) and received by a receiver (22) of a receiving connector part (12), wherein the transmitting connector part (11) and the receiving connector part (12) can be inserted into one another, and wherein the signal received by the receiver (22) being sensed by two independent sensing devices (34, 35) and being supplied to respective analysis devices (32, 36).

13. Method according to claim 12, **characterized in that** the analysis devices (32, 36) check whether the sensed signal corresponds to an anticipated signal.

14. Method according to claim 13, **characterized in that** a device connected to the connector is switched off depending on the analysis.

## Revendications

1. Ensemble de liaison enfichable (10, 100) comprenant une première partie de liaison enfichable et une deuxième partie de liaison enfichable qui peuvent être enfichées l'une dans l'autre, la deuxième partie de liaison enfichable étant conçue comme une partie de liaison enfichable de réception (12) comprenant un dispositif de réception (22) et le dispositif de réception (22) étant relié à un premier dispositif de détection (34, 35) destiné à détecter le signal reçu par le dispositif de réception (22), l'ensemble de liaison enfichable comportant le premier dispositif de détection (34, 35), la première partie de liaison enfichable étant conçue comme une partie de liaison enfichable d'émission (11) qui comporte un dispositif d'émission (20) destiné à la transmission sans contact d'un signal, **caractérisé en ce que** le dispositif de réception (22) est relié à un deuxième dispositif de détection (34, 35) destiné à détecter le signal reçu par le dispositif de réception (22), l'ensemble de liaison enfichable comportant le deuxième dispositif de détection (34, 35) en plus du premier dispositif de détection (34, 35).

2. Ensemble de liaison enfichable selon la revendication 1, **caractérisé en ce que** le premier et/ou le deuxième dispositif de détection (34, 35) sont reliés à un dispositif d'évaluation propre (32, 36) qui est adapté pour comparer le signal détecté par le dispositif de détection (34, 35) respectif avec un signal de référence.

3. Ensemble de liaison enfichable selon la revendication 2, **caractérisé en ce que** les dispositifs d'évaluation (32, 36) sont reliés les uns aux autres par une technologie de données.

4. Ensemble de liaison enfichable selon l'une des revendications précédentes, **caractérisé en ce que** la partie de liaison enfichable d'émission (11) et la partie de liaison enfichable de réception (12) comportent un guide de lumière (14).

5. Ensemble de liaison enfichable selon l'une des revendications précédentes, **caractérisé en ce que** la partie de liaison enfichable d'émission (11) est disposée à l'extrémité d'un câble de guidage de lumière (13) comportant un guide de lumière (14) et une ligne de signal (18) est prévue qui est guidée le long du câble de guidage de lumière (13).

6. Ensemble de liaison enfichable selon l'une des revendications précédentes, **caractérisé en ce qu'**un générateur de signaux (30) est prévu qui est relié au dispositif d'émission (20) et qui est relié à au moins un dispositif d'évaluation (32, 36, 101, 102) par une technologie de données.

7. Ensemble de liaison enfichable selon l'une des revendications précédentes, **caractérisé en ce que** le dispositif d'émission (20) comprend une bobine et le dispositif de réception (22) comprend un capteur à effet Hall.

8. Ensemble de liaison enfichable selon l'une des revendications 2 à 7, **caractérisé en ce que** les dispositifs d'évaluation (32, 36, 101, 102) sont réalisés sous la forme de microcontrôleurs.

9. Ensemble de liaison enfichable selon l'une des revendications 6 à 8 précédentes, **caractérisé en ce que** le générateur de signaux (30) comprend un microcontrôleur.

10. Ensemble de liaison enfichable selon l'une des revendications précédentes, **caractérisé en ce que** deux microcontrôleurs sont prévus, l'un du côté émission et l'autre du côté réception.

11. Ensemble de liaison enfichable selon l'une des revendications précédentes, **caractérisé en ce que** le dispositif d'émission (20) et/ou le dispositif de réception (22) sont disposés dans la partie de liaison enfichable (11, 12) respective en étant protégés par un matériau non magnétique.

12. Procédé de surveillance d'une liaison enfichable, dans lequel un signal variable dans le temps est émis sans contact par un dispositif d'émission (20) d'une partie de liaison enfichable d'émission (11) et est reçu par un dispositif de réception (22) d'une partie de liaison enfichable de réception (12), la partie de liaison enfichable d'émission (11) et la partie de liaison enfichable de réception (12) pouvant être enfichées l'une dans l'autre, et le signal reçu par le dispositif de réception (22) étant détecté par deux dispositifs de détection (34, 35) indépendants l'un de l'autre et étant amené à un dispositif d'évaluation (32, 36) respectif.

13. Procédé selon la revendication 12, **caractérisé en ce que** les dispositifs d'évaluation (32, 36) vérifient si le signal détecté correspond à un signal attendu.

14. Procédé selon la revendication 13, **caractérisé en ce qu'**un appareil raccordé à la liaison enfichable est désactivé en fonction de l'évaluation.
